(19) Europäisches Patentamt

European Patent Office

Office européen des brevets

(11) **EP 1 643 656 A1**

(12) **EUROPEAN PATENT APPLICATION**

(43) Date of publication:
**05.04.2006 Bulletin 2006/14**

(51) Int Cl.:
***H04B 1/69*** (2006.01)

(21) Application number: **04292335.9**

(22) Date of filing: **30.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicants:
• **Mitsubishi Electric Information Technology Centre**
**Europe B.V.**
**1119 NS Schiphol Rijk (NL)**
Designated Contracting States:
**FR**
• **MITSUBISHI DENKI KABUSHIKI KAISHA**
**Tokyo 100-8310 (JP)**
Designated Contracting States:
**AT BE BG CH CY CZ DE DK EE ES FI GB GR HU IE IT LI LU MC NL PL PT RO SE SI SK TR**

(72) Inventors:
• **Paquelet, Stéphane**
**CS 10806**
**35708 Rennes Cedex 7 (FR)**
• **Dore, Jean-Baptiste**
**CS 14315**
**35043 Rennes Cedex (FR)**
• **Haese, Sylvain**
**CS 14315**
**35043 Rennes Cedex (FR)**

(74) Representative: **Saint-Marc-Etienne, Christophe Andréas et al**
**Cabinet Le Guen & Maillet,**
**5, place Newquay, B.P. 70250**
**35802 Dinard Cedex (FR)**

(54) **Interleaved analog-to-digital converting and integrating circuit and telecommunication device comprising such a circuit**

(57) The invention relates to an integrator circuit (INT) including one or more integrating cells (ICL1...ICLP). The invention also relates to a telecommunication device comprising such a circuit.

The integrator circuit (INT) according to the invention includes:

·means (CM) for comparing an output signal of a given integrating cell with a first reference signal (V1), a second reference signal (V2) being then applied at the input of said given integrating cell, and

·means (CNT) for counting pulses of a clock signal (Cks) as long as said given integrating cell's output signal exceeds the first reference signal (V1).

By virtue of the invention, there is no physical seperation between integrating means and analog-to-digital converting means, such means being instead interleaved and interdependent, thus allowing to perform almost simultaneously the integration and the analog-to-digital conversion functions.

FIG.1

EP 1 643 656 A1

**Description**

The present invention relates to a circuit for performing an integration of an input signal, including :

- at least one integrating cell including an operational amplifier having an inverting input connected to an input terminal of the integrating cell *via* a resistor, and to an output of said operational amplifier forming an output terminal of said integrating cell *via* a capacitor, and
- switching means for selectively feeding the input of said at least one integrating cell with the input signal.

The invention also relates to a telecommunication device and to a telecommunication system including such a device.

A circuit as described in the opening paragraph has been disclosed in an article entitled "The CSI Chip — A CMOS Charge Successive Integrator With a Wide Dynamic Range for the Telescope Array Project", published in IEEE TRANSACTIONS ON NUCLEAR SCIENCE, Vol.49, No.4 in August 2002.

The known integrator makes use of three integrating cells for alternatively integrating an input signal, which enables each integrating cell to operate at a third of the speed which would be required of a single cell for integrating the same input signal.

The output signal of the known integrator is, however, of an analog nature and will have to be converted into digital if it is to be exploited by a processing unit such as a digital signal processor. Adding an analog-to-digital converter to the known charge-successive integrator will, however, raise its manufacturing cost and increase the overall size of the resulting circuit.

According to one of its aspects, the present invention aims at providing an electronic circuit able to perform an integration of an input signal and to deliver a digital output signal representative of this integration, which circuit only requires a small increase in size and complexity with respect to known circuits for achieving this purpose.

Indeed, according to the invention, a circuit as described in the opening paragraph is characterized in that it further includes:

- comparing means for comparing, when activated, an output signal delivered by an output terminal of said at least one integrating cell with a first reference signal, the switching means being intended to apply a second reference signal at the input of the integrating cell whose output signal is being compared to the first predetermined reference signal when the comparing means are activated, and
- counting means for counting clock pulses as long as the output signal delivered by said at least one integrating cell has a value wich exceeds that of the first reference signal.

In the circuit according to the invention, there is no physical seperation between means which would be specifically intended for integration purposes and means which would be specifically intended for analog-to-digital conversion purposes, such means being instead interleaved and interdependent, which enables to perform almost simultaneously the integration and the analog-to-digital conversion functions, without requiring a prohibitive increase in size and complexity with respect to the known charge-successive integrating circuit.

It should be noted here that the latter advantage may also be obtained, by virtue of the invention, with other types of integrating cells able to carry out a same function than that of the above-described negative RC-feedbacked operational amplifier while having a different internal structure, such other types of integrating cells being then functionnally equivalent to the one disclosed in the opening paragraph.

An integrator circuit as described hereinbefore may advantageously be used in a very wide range of applications, and is particularly well-suited for evaluating a power carried by a signal picked up by a receiving antenna belonging to a telecommunication device such as a mobile phone or any such transceiver.

More specifically, such an integrator circuit will be advantageously used according to another aspect of the invention for implementing a method for transmitting data in a telecommunication system including at least one transmitter and one receiver, said transmitter being intended to transmit a signal formed by at least one sequence of Ns pulses over Ns time windows, each pulse being enclosed within a time chip whose position whithin its relevant time window is defined by a chip number.

Such data transmission methods are currently studied with the aim of assessing the relevance of so-called Ultra-Wide Band telecommunication systems (further referred to as UWB systems). In such a system each transmitter may be identified by a signature formed by the above-mentioned chip numbers, which signature is in itself quite sturdy and may thus be reliably and accurately communicated to all potential receivers.

The pulses used in UWB systems are very short, having for example a duration lower than 0,1 nanosecond, which offers to such systems bandwidths at least as large as 10 GigaHertz, entailing high flexibility and hence numerous possible applications for such systems.

The above-described signal may form a carrying signal on which information can be encoded by modulation of said carrying signal. The inventors have observed that, because of the shortness of the pulses involved, a precise synchronization with a given pulse sequence will be difficult to perform at the receiver end, so that the chosen modulation scheme should involve as few time-related parameters as possible in order to be cost-efficient.

The inventors have thus chosen to modulate the amplitude of the UWB signals to be transmitted, e.g. by carrying out a multiplication, performed at the transmitting end, of each pulse sequence by an integer value representative of a symbol to be carried by said pulse sequence.

By virtue of this amplitude modulation scheme, the information carried by according UWB pulse sequences will essentially be related to the power carried by these signals, which power is related to the amplitude of the pulses included within such a signal. The inventors have found that such a modulation/demodulation scheme is easy to implement, which in turn enables to manufacture adapted transmitters and receivers at a relatively low cost.

A data transmission method as described hereinbefore thus preferably includes at least one symbol decoding step to be executed at the receiver end, in the course of which symbol decoding step at least one modulation value representative of an amount of power carried by each pulse sequence is computed and compared to at least one predetermined threshold value. Such a symbol decoding step enables to demodulate an UWB symbol in a very straightforward manner, by quantifying the power of the received signal and performing simple comparisons with one or several threshold values, which comparisons are easy to implement. Such a demodulation scheme does not require the receiver to perform a precise mapping, with respect to time, of the received signal, which eases the design of adapted receivers.

According to another one of its aspects, the invention hence also relates to a device adapted to receive a signal formed by at least one pulse sequence, which receiver includes symbol decoding means intended to compute at least one modulation value representative of an amount of power carried by each pulse sequence and to compare said modulation value to at least one predetermined threshold value, said symbol decoding means including squaring means for generating a squared signal representative of the result of a multiplication of the received signal by itself, and integrating means for computing an integrate value of said squared signal, which integrating means include at least one integrator circuit as described hereinbefore, the input signal of which being formed by said squared signal..

The use of the integrator circuit according to the invention for computing the power carried by an incoming signal will allow to obtain a digital value of said power, which may then be compared to a digital threshold value. This threshold value may be stored in a register and may thus be flexibly adjusted, amended and programmed.

According to a variant of the above-described modulation scheme, each signal to be transmitted will preferably be constituted by a superimposition of a predetermined number of pulse sequences, each pulse sequence having been subjected to a symbol encoding step and corresponding to one of several sub-bands into which a total bandwidth available for transmission has previously been divided.

This variant enables to transmit simultaneously several symbols through a same communication channel, and thus to significantly increase the throughput of a telecommunication system in which such a variant of the invention is embodied.

According to another one of its aspects, the invention thus also relates to a device adapted to receive a signal formed by at least one pulse sequence, which device comprises symbol decoding means including a plurality of signal decoders connected to a plurality of antennas and comprising each :

- energy splitting means for dispatching an incoming signal received by the relevant antenna into at least two sub-signals to be demodulated within respective frequency sub-bands, and
- signal demodulating means for identifying within each sub-signal a tunable coefficient which could have been applied to each sub-sequence before transmission of the incoming signal and would then be representative of a symbol carried by said sub-sequence, the signal demodulating means including an array of squaring modules, each of which being intended to receive a sub-signal and to deliver a signal constituted by a square of said sub-signal, and an array of integrator circuits as claimed in claim 1, each of which being connected to one of the squaring modules and intended to deliver a digital value representative of an amount of power carried by the corresponding sub-signal.

According to this other aspect of the invention, each signal decoder is linked to a single antenna optimized for a fraction of the total bandwidth available to the system. Each antenna, as well as each component included in the related signal decoder will thus have a limited frequential range of operation, which in turn eases the design of said antenna or component and enables to ensure that said antenna or component will have essentially constant physical properties within its own frequential range of operation, which may not be the case for a single antenna operating over a 10 GHz bandwidth.

According to yet another one of its aspects, the invention also relates to a telecommunication system including at least one transmitter and one receiver, said transmitter being intended to transmit a signal formed by at least one pulse sequence, system in which the receiver is formed by a device as described hereinbefore.

The characteristics of the invention mentioned above, as well as others, will emerge more clearly from a reading of the following description given in relation to the accompanying figures, amongst which:

Fig.1 is a schematic diagram depicting an integrator cicruit according to the invention;
Fig.2 is a functional diagram depicting a telecommunication system in which the invention is used;
Fig.3 is a chronogram depicting a pulse sequence constituting a carrying signal transmitted in such a telecommunication system;
Fig.4 is a chronogram depicting a pulse model which may be used for generating such a sequence;
Fig.5 is a chronogram depicting a data frame including a pluralty of pulse sequences;
Fig.6 is a block diagram depicting symbol decoding means included in a receiver in which a variant of the invention
is embodied; and
Fig.7 is a block diagram depicting a signal decoder included in symbol decoding means according to another aspect
of the invention.

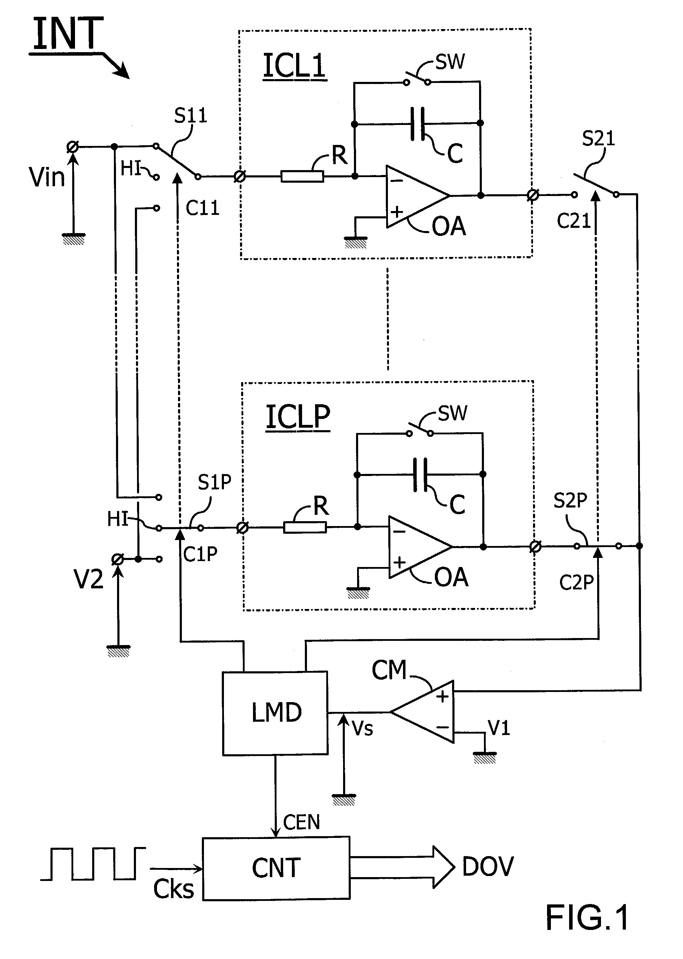

Fig.1 schematically depicts an integrator circuit INT for performing an integration of an input signal, in this
instance an input voltage Vin. This integrator circuit INT includes:

- a plurality of integrating cells ICL1...ICLP including each an operational amplifier OA having an inverting input
  connected to an input terminal of the integrating cell *via* a resistor R, and to an output of said operational amplifier
  forming an output terminal of said integrating cell *via* a capacitor C, and
- switching means S11...S1P for selectively feeding the input of said one of said integrating cells ICL1...ICLP with the
  input signal Vin.

The use of P parallel-arranged integrating cells for alternatively integrating the input signal Vin, enables each
integrating cell ICLp (for p=1 to P) to operate at a pace P times slower than that which would be required of a single cell
for integrating the same input signal.
The integrator circuit INT according to the invention further includes:

- comparing means CM for comparing, when activated by means of a switch S2p (for p=1 to P), an output signal
  delivered by an output terminal of one of said integrating cells ICLp with a first reference signal V1, chosen here to
  be equal to zero, the switching means S11... S1P being intended to apply a second reference signal V2 at the input
  of the integrating cell ICLp whose output signal is being compared to the first predetermined reference signal V1
  when the comparing means CM are activated, and
- counting means CNT for counting pulses of a clock signal Cks as long as the output signal delivered by said
  integrating cell ICLp has a value wich exceeds that of the first reference signal V1.

In this embodiment of the invention, the switches S11... S1P and S21... S2P are controlled by respective control
signals C11... C1P and C21... C2P delivered by a logic module LMD, which analyses the output signal Vs of the comparing
means CM and delivers an enabling/desabling signal CEN for respectively allowing or stopping the counting performed
by counting means CNT.
The integrator circuit INT operates as follows:
When a first switch, e.g. S11 is positioned so as to a allow the feeding of a first integrating cell ICL1 with the
input signal Vin, all other switches S12...S1P connected to the inputs of the other integrating cells ICL2...ICLP are in a
high impedance position HI. The capacitor C included in the actively integrating cell ICL1 is thus under charge through
resistor R, so that a voltage noted Vc delivered at the output terminal of said integrating cell ICL1 may be expressed as:

$$Vc = -\frac{1}{RC} \int_0^{Ti} Vin(t)dt \,,$$

where Ti represents the instant where the feeding of the input voltage Vin to the first integrating cell ICL1 will be interrupted
by switch S11, which is instead to feed the input of said first integrating cell ICL1 with the second reference voltage V2,
while the output of this integrating cell ICL1 is connected to the comparing means CM through switch S21.
During a time period $\Delta$T following this instant Ti, the output voltage of the first integrating cell ICL1 will be greater
than the first reference voltage V1, in this example greater than zero, so that during this time period $\Delta$T, Vs will be positive
and the counting means CNT will be allowed to count by a suitable value of enabling/desabling signal CEN delivered
by logic module LMD. The counting will be stopped when Vc=0, i.e. when Vc-$\Delta$T.V2/RC=0, which means that the the
counting time $\Delta$T will be proportional to Vc, and thus to the integrated value of Vin.

Moreover, the counter CNT will accumulate the successive integrated values delivered by all P integrating cells ICLp (for p=1 to P) and ultimately deliver a total integrated value presented in a digital form since constituted by the final contents DOV of the counter CNT.

Each integrated cell ICLp (for p=1 to P) will be re-initialized after having has its contents read by means of the above described comparison process, which is achieved by shortly closing switch SW in order to fully discharge capacitor C.

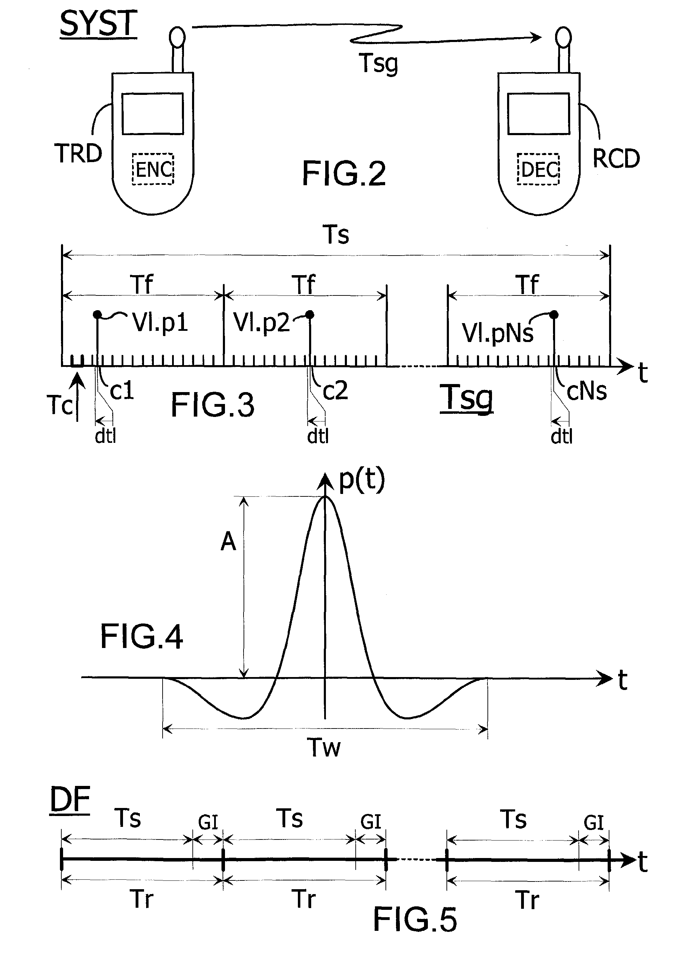

Fig.2 depicts a telecommunication system SYST in which the present invention is embodied. This system SYST includes at least one transmitter TRD and one receiver RCD, which may for example be both constituted by devices such as mobile phones. The transmitter TRD is intended to transmit a signal Tsg formed by at least one sequence of Ns pulses pj (for j=1 to Ns) over Ns time windows Tf, each pulse being enclosed within a time chip Tc whose position whithin its relevant time window is defined by a chip number cj (for j=1 to Ns). The number Ns of pulses included in this sequence may, for example, be chosen equal to 128, while the width of each time window Tf may be chosen equal to 100 nanoseconds, with a width of 1 nanosecond for each time chip Tc.

According to the present invention, the transmitter TRD includes symbol encoding means ENC intended to multiply each pulse sequence by a coding value representative of a symbol to be carried by said pulse sequence, and the receiver RCD includes symbol decoding means DEC intended to identify and recover said coding value from the contents of the transmitted signal Tsg.

The information carried by the transmitted signal Tsg will essentially be represented by the power carried by this signal Tsg, which power is related either to the amplitude of the pulses included within said signal Tsg if an amplitude modulation scheme is chosen, or simply to the number of pulses actually transmitted if an On/Off Keying modulation scheme is chosen. This information may then be recovered by the receiver RCD without said receiver RCD having to map precisely, with respect to time, the received pulse sequences.

Fig.3 depicts such a transmitted signal Tsg in the form of a chronogram, according to which each pulse sequence has a total duration duration Ts divided into time windows having each a duration Tf, each time window being sub-devided into time chips Tc, a single time chip within each window being intended to enclose a pulse pj (for j=1 to Ns), which single time chip is identified by means of a chip number cj. The transmitter of this transmitted signal Tsg will thus be identified by a signature Sg=(c1, c2...cNs) jointly formed by all above-mentioned chip numbers cj (for j=1 to Ns), which signature Sg is in itself quite sturdy and may thus be reliably and accurately communicated to all potential receivers.

In accordance with the invention, each pulse pj (for j=1 to Ns) belonging to the pulse sequence shown in this picture has been multiplied by a same tunable coding value V1 representative of a symbol to be carried by said pulse sequence, in the form of the power carried by this sequence, the reference "1" being indicative of a reference number allocated to the pulse sequence under consideration.

Furthermore, the pulses pj (for j=1 to Ns) are multiplied by values $\alpha j$ which are alternately chosen equal to +1 or —1 for a given sequence. In the example shown here, the pulses pj (for j=1 to Ns) are positive.

Such an alternate distribution of positive and negative pulses, which does not affect the information carried by said pulses because said information is related to the squares of said pulses, allows to prevent appearance of high-amplitude peaks in the spectral domain.

All pulses pj (for j=1 to Ns) of the pulse sequence shown here may additionnally be submitted to a time jitter dtl in the course of the symbol encoding step.

The time-jitter dtl introduced by the time-delaying means will be kept small with respect to a delay spread which will be induced by a communication channel through which the modulated signal will be transmitted. The delay spread may have, for example, a value of 30 to 100 nanoseconds, so that the chosen time-jitter dtl will preferably be lower than 5 nanoseconds. Such a time-jitter won't affect the information carried by each pulse sequence, and mainly adds an additionnal degree of flexibility to the modulation scheme according to the invention. Indeed, the time-jitter dtl may for all purposes be considered unknown at the receiver end.

The transmitted signal Tsg may thus be expressed in the following form :

$$Tsg(t) = \sum_{l,j} Vl.\alpha j.pj(t - cj - j.Tf - dtl)$$

In an alternative embodiment of the invention not shown here, the transmitted signal Tsg will preferably be constituted by a superimposition of a predetermined number of sub-sequences, each of which being modulated as explained hereinbefore.

In such an embodiment, each sub-sequence of rank k (with k=1 to K where K is the total number of sub-bands) will be expressed as :

$$Tsgk(t) = \sum_{l,j} Vkl.\alpha kj.pkj(t - ckj - j.Tf - dtkl) \, ,$$

with

$$Tsg(t) = \sum_{k} Tsgk(t)$$

This embodiment of the invention enables to transmit simultaneously several symbols through a same communication channel, and thus to significantly increase the throughput of such the system. This embodiment also enables to prevent narrow-band interference by allowing extraction of a sub-band polluted by a particular narrow-band transmission.

Moreover, a plurality of antennas may be used simultaneously for transmitting a plurality of signals Tsg as described above over a respective plurality of predetermined sub-bands into which a total bandwidth available for transmission has previously been divided, each signal Tsg having been delivered by a signal encoder connected to the related transmitting antenna.

Fig.4 is another chronogram which depicts a possible shape p(t) which may be chosen for constituting the above-mentioned pulses. Though pulses pj(t) (for j=1 to Ns) of a same sequence may have different shapes, provided that they all have essentially a same width and carry a same quantity of energy, all pulses pj(t) (for j=1 to Ns) should preferably have a same shape since it will be more cost-efficient to use a same pulse generator for producing them. The shape p(t) depicted in this example is defined as a derivative of the second order of a Gaussian function, which may be expressed mathematically as $p(t)=A.[1-4\pi(t/Tw)^2].\exp(-2\pi(t/Tw)^2)$. Other pulse shapes known to those skilled in the art may, of course, be used in this same purpose. A pulse generator intended to produce pulses having another shape will be described hereinafter.

Fig.5 is yet another chronogram which depicts a dataframe DF formed by successive pulse sequences such as the one described above, each having a total duration Ts, a guard interval GI being periodically inserted between two such sequences in order to prevent alteration of a given sequence by a following one, which alterations coud be caused, for example, by intermodulation products between said pulse sequences. This dataframe DF is thus constituted by successive frames having each a duration Tr, whith Tr=Ts+GI, and including each a pulse sequence as described above.

In particular applications, the signature of any given transmitter may be dynamically generated within said transmitter and may thus vary from one pulse sequence to another. Such a signature may for example be generated by means of a specific control of a pre-programmed shiftable register. In such applications, any given receiver must be able to re-generate each signature corresponding to each pulse sequence, which may be achieved by providing said receiver with a shiftable register to be pre-programmed and controlled according to instructions sent beforehand to said receiver by a control infrastructure of the telecommunication system, e.g. in the form of Medium Access Control signals.

A device intended to receive such a data frame DF must thus only be able to measure quantities representative of the successive amounts of power carried by the successive pulse sequences, in order to identify the informational content of the dataframe DF, without having to map precisely, with respect to time, the received pulse sequences.

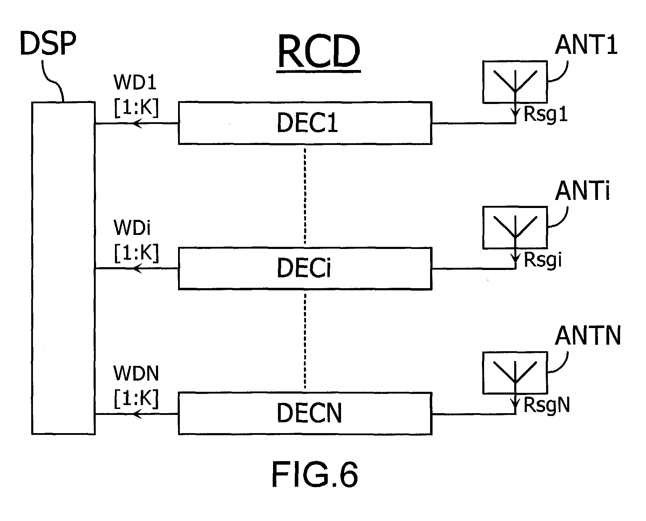

Fig.6 diagrammatically shows a receiving device RCD according to another aspect of the invention, which includes a plurality of signal decoders DECi (for i=1 to N) connected to a plurality of antennas ANTi (for i=1 to N). As explained hereinbefore, each antenna ANTi is intended to deliver to each signal encoder DECi an (for i=1 to N), each of which included K combined sub-sequences of pulses, each signal encoder DECi being in turn intended to deliver to a digital signal processor DSP coding words WDi[1:K] constituted by K coefficients originally applied to said K sub-sequences and extracted from said incoming signal Rsgi.

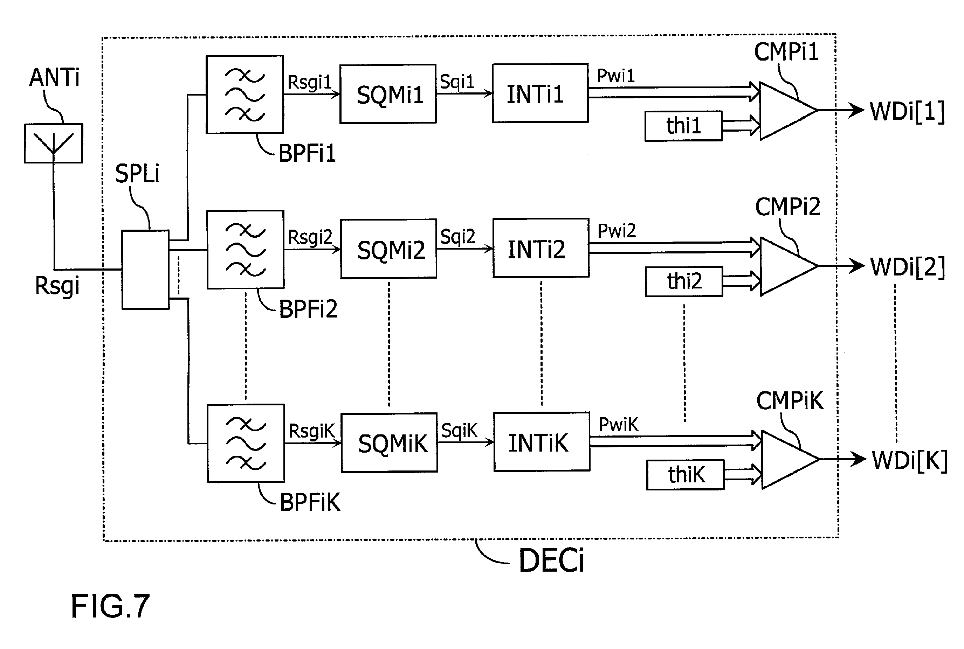

Fig.7 diagrammatically shows a signal decoder DECi included in the symbol decoding means described above. This signal encoder DECi includes:

- energy splitting means SPLi for dispatching an incoming signal Rsgi received by the relevant antenna into K sub-signals Rsgik (for k=1 to K) to be demodulated within respective frequency sub-bands, each sub-signal Rsgik potentially including a pulse sequence, and
- signal demodulating means for identifying within each sub-signal Rsgik (for k=1 to K) a tunable coefficient WDik which could have been applied to the relevant pulse sequence before transmission of the incoming signal and would then be representative of a symbol carried by said sub-sequence.

In this application where the information carried by a received signal Rsgik is related to the amplitude of the pulses included within such a signal and thus represented by the power carried by said signal, the signal demodulating means include an array of K squaring modules SQMik (with k=1 to K), each of which being connected to a band-pass filter BPFik and intended to receive a sub-signal Rsgik (with k=1 to K) and to deliver a signal Sqik constituted by a square of said sub-signal Rsgik. Each squaring module SQMik (for k=1 to K) may be formed by a Gilbert cell fed with identical input signals, or by a diode operating in its own square law region.

The signal demodulating means further include an array of K integrator circuits INTik (with k=1 to K) according to the embodiment of the invention described hereinbefore, each integrator circuit INTik being connected to one of the squaring modules SQMik and being intended to deliver a digital value Pwik representative of an amount of power carried by the corresponding sub-signal Rsgik. Such a digital value Pwik will be computed as the integral, on the duration of the channel delay, of the square signal Sqik delivered by the related squaring module SQMik.

The signal demodulating means also include an array of K digital comparators CMPik (with k=1 to K), each of which being connected to one of the integrating modules INTik and intended to compare the digital value Pwik to be delivered by each integrator circuit INTk with at a predetermined threshold value thik (with k=1 to K), which will have previously been stored in a register and may thus be flexibly adjusted or amended and dynamically programmed.

A tunable coefficient WDik (for k=1 to K) representative of a symbol carried by a given sub-signal Rsgik will thus be identified in a very straightforward manner, according to a simple decoding grid which may be expressed as follows :

- If Pwik<thik, then the tunable coefficient WDik carried by pulse sequence Tsk has a first value S0;
- If thik<Pwik, then the tunable coefficient WDik carried by pulse sequence Tsk has a second value S1.


**Claims**

1. A circuit for performing an integration of an input signal, including :

   . at least one integrating cell including an operational amplifier having an inverting input connected to an input terminal of the integrating cell *via* a resistor, and to an output of said operational amplifier forming an output terminal of said integrating cell *via* a capacitor, and
   . switching means for selectively feeding the input of said at least one integrating cell with the input signal, circuit **characterized in that** it further includes :
   . comparing means for comparing, when activated, an output signal delivered by an output terminal of said at least one integrating cell with a first reference signal, the switching means being intended to apply a second reference signal at the input of the integrating cell whose output signal is being compared to the first predetermined reference signal when the comparing means are activated, and
   . counting means for counting clock pulses as long as the output signal delivered by said at least one integrating cell has a value wich exceeds that of the first reference signal.

2. A device adapted to receive a signal formed by at least one pulse sequence, which device includes symbol decoding means intended to compute at least one modulation value representative of an amount of power carried by each pulse sequence and to compare said modulation value to at least one predetermined threshold value, said symbol decoding means including squaring means for generating a squared signal representative of the result of a multiplication of the received signal by itself, and integrating means for computing an integrated value of said squared signal, which integrating means include at least one circuit as claimed in claim 1, the input signal of which being formed by said squared signal.

3. A device adapted to receive a signal formed by at least one pulse sequence, which device comprises symbol decoding means including a plurality of signal decoders connected to a plurality of antennas and comprising each :

   . energy splitting means for dispatching an incoming signal received by the relevant antenna into at least two sub-signals to be demodulated within respective frequency sub-bands, and
   . signal demodulating means for identifying within each sub-signal a tunable coefficient which could have been applied to each sub-sequence before transmission of the incoming signal and would then be representative of a symbol carried by said sub-sequence, the signal demodulating means including an array of squaring modules, each of which being intended to receive a sub-signal and to deliver a signal constituted by a square of said sub-signal, and an array of integrator circuits as claimed in claim 1, each of which being connected to one of the squaring modules and intended to deliver a digital value representative of an amount of power carried by the corresponding sub-signal.

4. A telecommunication system including at least one transmitter and one receiver, said transmitter being intended to transmit a signal formed by at least one pulse sequence, system in which the receiver is formed by a device as claimed in claims 2 or 3.

FIG.1

SYST

FIG.2

TRD

ENC

Tsg

DEC

RCD

Ts

Tf

Tf

Tf

Vl.p1

Vl.p2

Vl.pNs

t

Tc

c1

FIG.3

c2

Tsg

cNs

dtl

dtl

dtl

p(t)

A

FIG.4

t

Tw

DF

Ts

GI

Ts

GI

Ts

GI

t

Tr

Tr

FIG.5

Tr

FIG.6

FIG.7

EP 1 643 656 A1

## EP 1 643 656 A1

**European Patent Office**

**EUROPEAN SEARCH REPORT**

Application Number

EP 04 29 2335

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 763 057 B1 (BRETHOUR VERNON R ET AL) 13 July 2004 (2004-07-13) * figure 23a * | 2,4 | H04B1/69 |
| A | MILLER L E: "Autocorrelation functions for Hermite-polynomial ultra-wideband pulses" ELECTRONICS LETTERS, IEE STEVENAGE, GB, vol. 39, no. 11, 29 May 2003 (2003-05-29), pages 870-871, XP006020366 ISSN: 0013-5194 * the whole document * | 1-4 | |
| X | EP 0 502 368 A (YOKOGAWA INSTR CORP) 9 September 1992 (1992-09-09) * figure 5 * | 1 | |
| X | US 4 243 975 A (MASUDA EIJI ET AL) 6 January 1981 (1981-01-06) * figure 3 * | 1 | |
| Y | US 2002/190786 A1 (YOON YOUNG C ET AL) 19 December 2002 (2002-12-19) * paragraph [0075]; figure 8 * | 2-4 | TECHNICAL FIELDS SEARCHED (Int.Cl.7) H04B |
| Y | EP 1 303 056 A (GEN ELECTRIC) 16 April 2003 (2003-04-16) * paragraph [0029]; figure 4 * | 2-4 | |
| X | US 4 366 468 A (YONEYAMA TOSHIKAZU) 28 December 1982 (1982-12-28) * figures 3,4 * | 1 | |
| X | US 6 505 032 B1 (MCCORKLE JOHN W ET AL) 7 January 2003 (2003-01-07) * figure 2 * | 3 | |

-/--

The present search report has been drawn up for all claims

| Place of search | Date of completion of the search | Examiner |
|---|---|---|
| Munich | 18 January 2005 | Müller, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 04 29 2335

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | HOCTOR R T: "Multiple access capacity in multipath channels of delay-hopped transmitted-reference UWB" ULTRA WIDEBAND SYSTEMS AND TECHNOLOGIES, 2003 IEEE CONFERENCE ON NOV. 16-19, 2003, PISCATAWAY, NJ, USA,IEEE, 16 November 2003 (2003-11-16), pages 315-319, XP010683780 ISBN: 0-7803-8187-4 * paragraph [0001] * | 2-4 | |
| X | PAUSINI M ET AL: "Analysis and comparison of autocorrelation receivers for IR-UWB signals based on differential detection" ACOUSTICS, SPEECH, AND SIGNAL PROCESSING, 2004. PROCEEDINGS. (ICASSP '04). IEEE INTERNATIONAL CONFERENCE ON MONTREAL, QUEBEC, CANADA 17-21 MAY 2004, PISCATAWAY, NJ, USA,IEEE, vol. 4, 17 May 2004 (2004-05-17), pages 513-516, XP010718518 ISBN: 0-7803-8484-9 * figure 1 * | 2,4 | |
| X | WITHINGTON P ET AL: "Preliminary results of an ultra-wideband (impulse) scanning receiver" MILITARY COMMUNICATIONS CONFERENCE PROCEEDINGS, 1999. MILCOM 1999. IEEE ATLANTIC CITY, NJ, USA 31 OCT.-3 NOV. 1999, PISCATAWAY, NJ, USA,IEEE, US, vol. 2, 31 October 1999 (1999-10-31), pages 1186-1190, XP010369746 ISBN: 0-7803-5538-5 * figure 1 * | 3 | TECHNICAL FIELDS SEARCHED (Int.Cl.7) |

The present search report has been drawn up for all claims

| Place of search | Date of completion of the search | Examiner |
|---|---|---|
| Munich | 18 January 2005 | Müller, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 04 29 2335

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2005

| Patent document cited in search report | | Publication date | Patent family member(s) | | Publication date |
|---|---|---|---|---|---|
| US 6763057 | B1 | 13-07-2004 | AU | 2073201 A | 18-06-2001 |
| | | | EP | 1236327 A1 | 04-09-2002 |
| | | | JP | 2003521143 T | 08-07-2003 |
| | | | WO | 0143386 A1 | 14-06-2001 |
| EP 0502368 | A | 09-09-1992 | JP | 2512349 B2 | 03-07-1996 |
| | | | JP | 4277929 A | 02-10-1992 |
| | | | DE | 69219506 D1 | 12-06-1997 |
| | | | DE | 69219506 T2 | 06-11-1997 |
| | | | DE | 502368 T1 | 18-03-1993 |
| | | | EP | 0502368 A2 | 09-09-1992 |
| | | | US | 5216426 A | 01-06-1993 |
| US 4243975 | A | 06-01-1981 | JP | 54051454 A | 23-04-1979 |
| US 2002190786 | A1 | 19-12-2002 | JP | 2002271428 A | 20-09-2002 |
| EP 1303056 | A | 16-04-2003 | US | 2003069026 A1 | 10-04-2003 |
| | | | EP | 1303056 A2 | 16-04-2003 |
| | | | JP | 2003169000 A | 13-06-2003 |
| US 4366468 | A | 28-12-1982 | JP | 1387396 C | 14-07-1987 |
| | | | JP | 56014721 A | 13-02-1981 |
| | | | JP | 61059569 B | 17-12-1986 |
| US 6505032 | B1 | 07-01-2003 | AU | 6457301 A | 11-12-2001 |
| | | | EP | 1302001 A2 | 16-04-2003 |
| | | | JP | 2003535557 T | 25-11-2003 |
| | | | WO | 0193482 A2 | 06-12-2001 |
| | | | US | 2003054764 A1 | 20-03-2003 |
| | | | US | 2003162498 A1 | 28-08-2003 |
| | | | US | 2003096578 A1 | 22-05-2003 |
| | | | AU | 1157102 A | 22-04-2002 |
| | | | WO | 0231988 A2 | 18-04-2002 |
| | | | US | 2002064245 A1 | 30-05-2002 |
| | | | AU | 6127701 A | 11-12-2001 |
| | | | AU | 6127801 A | 11-12-2001 |
| | | | AU | 6300701 A | 11-12-2001 |
| | | | AU | 6300801 A | 11-12-2001 |
| | | | AU | 6457401 A | 11-12-2001 |
| | | | AU | 6457501 A | 11-12-2001 |
| | | | AU | 7481901 A | 11-12-2001 |
| | | | AU | 7482001 A | 11-12-2001 |
| | | | EP | 1284049 A1 | 19-02-2003 |
| | | | WO | 0193442 A1 | 06-12-2001 |
| | | | WO | 0193434 A2 | 06-12-2001 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 04 29 2335

This annex lists the patent family members relating to the patent documents cited in the above-mentioned European search report.
The members are as contained in the European Patent Office EDP file on
The European Patent Office is in no way liable for these particulars which are merely given for the purpose of information.

18-01-2005

| Patent document cited in search report | Publication date | Patent family member(s) | Publication date |
|---|---|---|---|
| US 6505032 B1 | | WO 0193519 A1 | 06-12-2001 |
| | | WO 0193443 A2 | 06-12-2001 |
| | | WO 0193444 A1 | 06-12-2001 |
| | | WO 0193445 A2 | 06-12-2001 |
| | | WO 0193520 A2 | 06-12-2001 |
| | | WO 0193446 A2 | 06-12-2001 |
| | | US 2003161411 A1 | 28-08-2003 |
| | | US 6735238 B1 | 11-05-2004 |
| | | US 6834073 B1 | 21-12-2004 |
| | | AU 5882200 A | 11-12-2001 |
| | | EP 1295405 A1 | 26-03-2003 |
| | | JP 2003535552 T | 25-11-2003 |
| | | WO 0193441 A1 | 06-12-2001 |

EPO FORM P0459

For more details about this annex : see Official Journal of the European Patent Office, No. 12/82